(19) Europäisches Patentamt
European Patent Office
Office européen des brevets

(11) **EP 4 737 408 A1**

(12) **EUROPEAN PATENT APPLICATION**

(43) Date of publication:
**06.05.2026 Bulletin 2026/19**

(21) Application number: **25211743.7**

(22) Date of filing: **28.10.2025**

(51) International Patent Classification (IPC):
**C03C 3/076** (2006.01)   **C03B 1/00** (2006.01)
**C03C 15/00** (2006.01)   **C03C 17/36** (2006.01)
**C03C 17/38** (2006.01)

(52) Cooperative Patent Classification (CPC):
**C03C 15/00; C03B 25/025; C03C 3/076;
C03C 17/36; C03C 17/38;** C03C 2218/31;
C03C 2218/33

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **31.10.2024 US 202463714157 P
31.10.2024 US 202463714155 P**

(71) Applicant: **Absolics Inc.
Covington, GA 30014 (US)**

(72) Inventors:
• **KIM, Sungjin
Covington, Georgia, 30014 (US)**
• **KIM, Jincheol
18469 Hwaseong-si, Gyeonggi-do (KR)**

(74) Representative: **BCKIP Part mbB
MK1
Landsbergerstraße 98, 3.Stock
80339 München (DE)**

(54) **SUBSTRATE AND SEMICONDUCTOR PACKAGE COMPRISING THE SAME**

(57)   According to the present disclosure, a substrate comprises a glass core. The glass core comprises a through via penetrating the glass core in a thickness direction. A diameter of the through via is 50 $\mu$m to 100 $\mu$m. A sum of a sulfur content (atomic %) and a nitrogen content (atomic %) of the glass core is 0.2 atomic % to 8 atomic %.

In this case, it may be possible to provide a substrate that achieves more stable electrical connection through the glass core and exhibits stable durability and electrical reliability even under a high-humidity environment.

FIG. 1A

100

EP 4 737 408 A1

## Description

This application claims the priority benefit of U.S. Provisional Patent Application No. 63/714,155, filed on October 31, 2024, and U.S. Provisional Patent Application No. 63/714,157, filed on October 31, 2024.

## TECHNICAL FIELD

The present disclosure relates to a substrate and semiconductor package including the same.

## BACKGROUND

In manufacturing electronic components, implementing a circuit on a semiconductor wafer is called a front-end process (FE: Front-End), and assembling the wafer into a state usable in an actual product is called a back-end process (BE: Back-End), and a packaging process is included in the back-end process.

Recently, the four core technologies of the semiconductor industry that have enabled the rapid development of electronic products are semiconductor technology, semiconductor packaging technology, manufacturing process technology, and software technology. Although semiconductor technology has developed in various forms, such as submicron to nanometer-scale line widths, more than tens of millions of cells, high-speed operation, and significant heat dissipation, the technology to perfectly package the same has not been sufficiently supported in comparison. Accordingly, the electrical performance of a semiconductor may be determined by the packaging technology and the resulting electrical connection rather than by the performance of the semiconductor technology itself.

As materials for a substrate 100, ceramic or resin is applied. In the case of a ceramic substrate, it is not easy to mount a high-performance, high-frequency semiconductor device due to a high resistance value or a high dielectric constant. In the case of a resin substrate, although a high-performance, high-frequency semiconductor device can be mounted relatively, there is a limitation in reducing the pitch of wiring.

Recently, studies have been conducted in which silicon or glass is applied as a high-end substrate 100. By forming a through hole in a silicon or glass substrate and applying an electrically conductive material to the through hole, the wiring length between a device and a motherboard can be shortened and excellent electrical characteristics can be obtained.

## SUMMARY

A substrate according to one embodiment of the present specification comprises a glass core.

The glass core comprises a through via penetrating the glass core in a thickness direction.

A diameter of the through via is 50 $\mu$m to 100 $\mu$m.

A sum of a sulfur content (atomic %) and a nitrogen content (atomic %) of the glass core may be 0.2 atomic % to 8 atomic %.

The glass core comprises 0.1 atomic % to 3 atomic % of sulfur.

The glass core may comprise 0.1 atomic % to 5 atomic % of nitrogen.

The through via may comprise an internal space and a via inner wall surrounding the internal space.

The glass core may comprise an upper surface and a lower surface facing the upper surface.

The through via may have a diameter varying in the thickness direction of the substrate.

The through via may comprise a first opening in contact with the upper surface of the glass core, a second opening in contact with the lower surface of the glass core, and a minimum inner diameter portion having a smallest diameter and connecting the first opening and the second opening.

When observed in a cross-section in the thickness direction of the glass core, an angle formed between the via inner wall connecting the minimum inner diameter portion and the first opening and a vertical line to the upper surface of the glass core may be 0.1° to 8°.

The substrate may comprise a conductive layer formed on the via inner wall.

The conductive layer may comprise a seed layer and a conductor layer disposed on the seed layer.

A thickness of the seed layer may be 50 nm to 500 nm.

The substrate may further comprise an insulating layer disposed on the glass core.

The insulating layer may comprise an insulating resin.

A hydrophilicity index (Ih) of the insulating layer represented by Equation 1 below may be 7 to 12.

[Equation 1]

$$Ih = \frac{Rcc}{Rco}$$

In Equation 1, the Rcc value is an abundance ratio of carbon-carbon bonds to total carbon-element bonds, and the Rco value is an abundance ratio of carbon-oxygen bonds to total carbon-element bonds.

The insulating layer may comprise a filler.

The filler may comprise silica.

A moisture resistance index (Irw) of the insulating layer represented by Equation 2 below may be 0.03 % to 0.1 %.

[Equation 2]

$$Irw = Rso(\%) + Rsc(\%)$$

In Equation 2, the Rso value is an abundance ratio (%) of Si-O single bonds to total Si-element bonds, and the Rsc value is an abundance ratio (%) of Si-C single bonds to total Si-element bonds.

An abundance ratio of carbon-carbon double bonds to total carbon-element bonds of the insulating layer may be 12 % to 17 %.

A moisture absorption rate of the substrate measured after immersion in water at 23 °C for 24 hours may be 0.1 % or less.

A tensile strength of the substrate may be 60 MPa or more.

The filler may further comprise a metal oxide.

The filler may comprise 30 wt % to 70 wt % of the metal oxide.

The insulating resin may comprise an epoxy-based resin.

The epoxy-based resin may comprise a first residue derived from a bisphenol-type epoxy-based resin and a second residue derived from a novolac-type epoxy-based resin.

The substrate may be for use in a semiconductor package.

A substrate according to another embodiment of the present specification comprises a glass core and an insulating layer disposed on the glass core.

The insulating layer comprises an insulating resin.

A hydrophilicity index (Ih) of the insulating layer represented by Equation 1 below is 7 to 12.

[Equation 1]

$$Ih = \frac{Rcc}{Rco}$$

In Equation 1, the Rcc value is an abundance ratio of carbon-carbon bonds to total carbon-element bonds, and the Rco value is an abundance ratio of carbon-oxygen bonds to total carbon-element bonds.

A semiconductor package according to another embodiment of the present specification comprises the substrate and a device electrically connected to the substrate.

**BRIEF DESCRIPTION OF THE DRAWINGS**

FIG. 1A is a cross-sectional view describing a substrate according to one embodiment of the present disclosure.

FIG. 1B is an enlarged view of A indicated in FIG. 1A.

FIG. 2 is a cross-sectional view describing a substrate according to another embodiment of the present disclosure.

FIG. 3 is a cross-sectional view describing a substrate 100 according to yet another embodiment of the present disclosure.

FIG. 4 is a cross-sectional view describing a substrate 100 according to yet another embodiment of the present disclosure.

FIG. 5 is a cross-sectional view describing a substrate 100 according to yet another embodiment of the present disclosure.

## DETAILED DESCRIPTION

Hereinafter, embodiments will be described in detail with reference to the accompanying drawings so that those skilled in the art to which the present disclosure pertains may easily implement the same. However, the present invention may be implemented in various different forms and is not limited to the embodiments described herein. Throughout the specification, the same reference numerals are attached to similar parts.

Throughout the present specification, the term "combinations thereof" included in Markush-type expressions is to be understood as meaning one or more mixtures or combinations selected from the group of components described in the Markush-type expression, and as meaning that one or more selected from the group of the components are included.

In the present specification, terms such as "first", "second" or "A", "B" are used to distinguish the same terms from each other. In addition, unless clearly indicated otherwise by the context, singular expressions include plural expressions.

In the present specification, the expression "~ based" may mean that a compound corresponding to "~" and/or a derivative of "~" is included in the compound.

In the present specification, that B is located "on" A means that B is located directly in contact with A or that B is located on A with another layer interposed therebetween, and is not construed as being limited to B being located in contact with the surface of A.

In the present specification, that B is connected to A means that A and B are directly connected or that A and B are connected through another component interposed between A and B, and unless otherwise specifically mentioned, it is not construed as being limited to A and B being directly connected.

In the present specification, unless otherwise specifically described, a singular expression is interpreted to include a singular or plural as construed by the context.

In the present specification, the shapes, relative sizes, angles, etc. of the respective components in the drawings are illustrative and may be exaggerated for the purpose of explanation, and the rights are not construed as being limited to the drawings.

In the present specification, that A and B are "adjacent" means that A and B are positioned in contact with each other or that A and B are positioned close to each other without being in contact. In the present specification, unless otherwise specifically mentioned, the expression that A and B are adjacent is not construed as being limited to A and B being positioned in contact.

In the present specification, a "fine line" means, unless otherwise described, a line having a width of 5 $\mu$m or less, or exemplarily means a line having a width of 1 to 4 $\mu$m or less.

In the present specification, unless otherwise specifically described, the physical property values of each component in the substrate are interpreted as those measured at room temperature. The room temperature is 20 °C to 25 °C.

The thinner the width and thickness of the conductive layer formed in the substrate, the higher the likelihood of issues related to electrical reliability of the substrate. In particular, due to plating defects of the conductive layer within the through via penetrating the substrate, signal transmission connecting the upper and lower sides of the substrate may not proceed smoothly.

The inventors of the present disclosure confirmed that an electrical connection penetrating a glass core may be stably formed through a substrate to which the technical features described below are applied, and completed the present disclosure.

Hereinafter, the present disclosure will be described in detail.

Shape of Glass Core

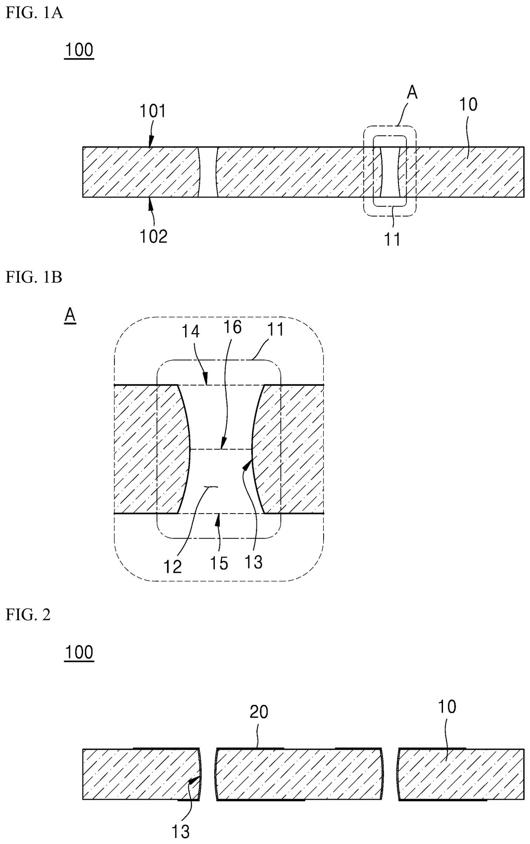

FIG. 1A is a cross-sectional view describing a substrate according to one embodiment of the present disclosure, and FIG. 1B is an enlarged view of A indicated in FIG. 1A. Hereinafter, the present disclosure will be described with reference to FIGS. 1A and 1B.

A substrate 100 according to one embodiment of the present disclosure comprises a glass core 10.

The glass core 10 has a substrate shape and may function as a support layer in the substrate 100. By way of example, the glass core 10 may be applied as alkali borosilicate flat glass, alkali-free borosilicate flat glass, or alkali-free alkaline-earth borosilicate flat glass, etc.

A surface of the glass core 10 may comprise an upper surface 101 and a side surface formed in a thickness direction of the glass core 10 and connected to the upper surface 101. The surface of the glass core 10 may comprise a lower surface 102 facing the upper surface 101.

That the side surface is formed in the thickness direction of the glass core 10 is to be interpreted to include not only that the side surface forms a perpendicular with the upper surface 101 of the glass core 10, but also that at least a portion of the side surface forms, with the upper surface 101, an angle other than 90 degrees (an inclination angle).

The side surface may be a plane, or may be a curved surface.

The glass core 10 may comprise a cavity (not shown), which is a space formed by an inward recess.

The cavity may be formed by a portion of the upper surface 101 and/or the lower surface 102 side of the glass core 10 being recessed in the thickness direction of the glass core 10, or may be formed to penetrate in the thickness direction of the glass core 10.

A device may be mounted in the cavity and the substrate 100 and the device may be electrically connected. The device may be not only a semiconductor device such as a CPU, GPU, or memory chip, but also a capacitor device, a transistor device, an impedance device, or another module. That is, as long as it is a semiconductor device mounted in a semiconductor apparatus, it may be applied as the device without limitation.

A thickness of the glass core 10 may be 100 $\mu$m to 1,000 $\mu$m. The thickness may be 200 $\mu$m or more. The thickness may be 300 $\mu$m or more. The thickness may be 900 $\mu$m or less. The thickness may be 800 $\mu$m or less. The thickness may be 700 $\mu$m or less. In such a case, the glass core 10 may function as a stable support in the substrate 100.

The glass core 10 may comprise a through via 11 penetrating the glass core 10 in the thickness direction.

The through via 11 is constituted by an internal space 12 and a via inner wall 13 surrounding the internal space 12. The internal space 12 means a void space, and the via inner wall 13 means a surface of the glass core 10 formed inside the through via 11.

The through via 11 may have a diameter varying in the thickness direction of the glass core 10. The through via 11 may have a substantially uniform diameter in the thickness direction of the glass core 10.

A diameter of the through via 11 may be 50 $\mu$m to 100 $\mu$m. The diameter may be 60 $\mu$m or more. The diameter may be 90 $\mu$m or less. In such a case, while forming high-density through vias 11 in the glass core 10, sufficient space may be secured to form a fine pattern in the through via 11.

When the through via 11 has a diameter varying in the thickness direction of the glass core 10, a diameter of the through via 11 is measured from a portion having a minimum diameter in the through via 11.

The glass core 10 may comprise the upper surface 101 and the lower surface 102 facing the upper surface 101. The through via 11 may have a diameter varying in the thickness direction of the substrate 100. The through via 11 may comprise a first opening 14 contacting the upper surface 101 of the glass core, a second opening 15 contacting the lower surface 102 of the glass core, and a minimum inner diameter portion 16 having a smallest diameter and connecting the first opening 14 and the second opening 15. In such a case, when observed in a cross-section in the thickness direction of the glass core 10, a cross-section of the through via 11 may have an hourglass shape.

The present disclosure may further improve the electrical reliability of a conductive layer formed in the through via 11 by controlling an angle of the via inner wall 13. Through this, when forming a seed layer, which will be described below, on the via inner wall 13 by sputtering, sputtered particles may be deposited more uniformly over the entire via inner wall 13.

When observed in a cross-section in the thickness direction of the glass core, an angle formed between the via inner wall 13 connecting the minimum inner diameter portion 16 and the first opening 14, and a vertical line with respect to the upper surface 101 of the glass core, may be 0.1° to 8°. The angle may be 0.5° or more. The angle may be 1° or more. The angle may be 2° or more. The angle may be 7° or less. The angle may be 6° or less.

When observed in a cross-section in the thickness direction of the glass core 10, an angle formed between the via inner wall 13 connecting the minimum inner diameter portion 16 and the second opening 15, and a vertical line with respect to the lower surface 102 of the glass core, may be 0.1° to 8°. The angle may be 0.5° or more. The angle may be 1° or more. The angle may be 2° or more. The angle may be 7° or less. The angle may be 6° or less.

In such a case, defects due to plating failure when forming a conductive layer in the through via 11 may be effectively suppressed.

A diameter of the minimum inner diameter portion 16 may be 50 $\mu$m to 100 $\mu$m. The diameter may be 60 $\mu$m or more. The diameter may be 90 $\mu$m or less.

A diameter of the first opening 14 may be 60 $\mu$m to 120 $\mu$m. The diameter may be 70 $\mu$m or more. The diameter may be 110 $\mu$m or less.

A diameter of the second opening 15 may be 60 $\mu$m to 120 $\mu$m. The diameter may be 70 $\mu$m or more. The diameter may be 110 $\mu$m or less.

In such a case, this may help the via inner wall 13 to have an inclination angle suitable for a sputtering process.

Composition and Physical Properties of Glass Core

In the process of forming the glass core 10 from molten glass, a fining agent including sulfur and/or nitrogen may be applied to remove bubbles remaining in the molten glass. The fining agent may be reduced and then oxidized in the molten glass, and may be chemically dissolved in the glass core 10. However, if a part of the compound formed by reduction of the fining agent is not oxidized, or if the chemical solubility of sulfur oxide or nitrogen gas derived from the fining agent in the glass core 10 is insufficient to the glass core 10, bubbles derived from the fining agent may be formed in the glass core 10. The bubbles may be a significant obstacle in precisely forming the through via 11 having a fine diameter.

The present disclosure may control a sum of a sulfur content and a nitrogen content in the glass core 10 within a predetermined range. Through this, bubbles remaining in the molten glass may be effectively removed by the fining agent, and defects in the through via 11 caused by sulfur oxide and/or nitrogen gas may be effectively suppressed.

A sum of the sulfur content (atomic %) and the nitrogen content (atomic %) of the glass core 10 may be 0.2 atomic % to 8 atomic %. The sum of the sulfur content (atomic %) and the nitrogen content (atomic %) of the glass core 10 may be 1 atomic % or more. The sum of the sulfur content (atomic %) and the nitrogen content (atomic %) of the glass core 10 may be 2 atomic % or more. The sum of the sulfur content (atomic %) and the nitrogen content (atomic %) of the glass core 10 may be 6 atomic % or less. In such a case, the shape of the through via 11 in the glass core 10 may be more precisely controlled.

The glass core 10 may comprise 0.1 atomic % to 3 atomic % of sulfur. The glass core 10 may comprise 0.5 atomic % or more of sulfur. The glass core 10 may comprise 1 atomic % or more of sulfur. The glass core 10 may comprise 2.5 atomic % or less of sulfur. In such a case, bubbles in the glass core 10 may be effectively removed, while defects derived from sulfur oxide that may occur in the process of forming the through via 11 may be suppressed.

The glass core 10 may comprise 0.1 atomic % to 5 atomic % of nitrogen. The glass core 10 may comprise 0.5 atomic % or more of nitrogen. The glass core 10 may comprise 1 atomic % or more of nitrogen. The glass core 10 may comprise 4 atomic % or less of nitrogen. The glass core 10 may comprise 3 atomic % or less of nitrogen. In such a case, formation of bubbles in the glass core 10 caused by reduced chemical solubility of nitrogen may be suppressed.

A sum of an oxygen content (atomic %) and a silicon content (atomic %) of the glass core 10 may be 90 atomic % or more. The sum of the oxygen content (atomic %) and the silicon content (atomic %) of the glass core 10 may be 92 atomic % or more. The sum of the oxygen content (atomic %) and the silicon content (atomic %) of the glass core 10 may be 99 atomic % or less.

The glass core 10 may comprise 50 atomic % or more of oxygen. The glass core 10 may comprise 55 atomic % or more of oxygen. The glass core 10 may comprise 60 atomic % or more of oxygen. The glass core 10 may comprise 80 atomic % or less of oxygen.

The glass core 10 may comprise 10 atomic % or more of silicon. The glass core 10 may comprise 15 atomic % or more of silicon. The glass core 10 may comprise 20 atomic % or more of silicon. The glass core 10 may comprise 40 atomic % or less of silicon.

The glass core 10 may further comprise elements other than those mentioned above. For example, the glass core 10 may further comprise titanium, boron, sodium, calcium, or potassium.

The content of each element of the glass core 10 is measured by XPS (X-ray Photoelectron Spectroscopy). Specifically, an area of 1 cm in width and 1 cm in length in the glass core 10 is measured by an XPS microprobe in narrow scan mode. In the measurement, 15 scans, a beam size of 650 $\mu$m, a step of 0.05 eV, and a CAE 20 pass energy are applied as measurement conditions. For example, ESCALAB of Thermo may be applied as the XPS microprobe.

The element content of the glass core is a value converted such that the total sum of the contents of elements except carbon among the detected elements becomes 100 atomic %.

In the case of the present disclosure, formation of voids caused by bubbles in a region of the glass core 10 where the through via 11 is formed may be effectively suppressed, and the via inner wall 13 may have a smoother surface.

<u>Conductive Layer</u>

FIG. 2 is a cross-sectional view illustrating a substrate according to another embodiment of the present disclosure. Hereinafter, the present disclosure will be described with reference to FIG. 2.

The substrate 100 comprises a glass core 10. The glass core 10 comprises a through via 11 penetrating the glass core 10 in a thickness direction. For the components of the substrate 100, the same description as provided in FIGS. 1A and 1B above is applied. The following description focuses on the differences.

The substrate 100 may comprise a conductive layer 20 formed on a via inner wall 13. The conductive layer 20 may be disposed in contact with the via inner wall 13. The substrate 100 may further comprise a conductive layer 20 formed on the glass core 10. The substrate 100 may further comprise a conductive layer 20 formed under the glass core 10.

The conductive layer 20 may comprise a seed layer (not shown) and a conductor layer (not shown) disposed on the seed layer. The conductive layer 20 serves as a path through which an electrical signal is transmitted. The seed layer may help the conductor layer be stably attached on a surface of the glass core 10 or an insulating layer. The conductor layer may provide electrical connection within the substrate 100.

The present disclosure may control a thickness of the seed layer formed on the via inner wall 13. Through this, the conductive layer 20 having stable bonding strength with the via inner wall 13 formed by etching may be formed.

A thickness of the seed layer may be 50 nm to 500 nm. The thickness may be 100 nm or more. The thickness may be 150 nm or more. The thickness may be 180 nm or more. The thickness may be 200 nm or more. The thickness may be 450 nm or less. The thickness may be 400 nm or less.

The seed layer may comprise a first seed layer and a second seed layer disposed on the first seed layer. The first seed layer may comprise a metal element different from a metal element applied to the conductor layer. The first seed layer may comprise one selected from the group consisting of titanium, nickel, chromium, and combinations thereof. The first seed layer may comprise titanium.

The second seed layer may comprise a metal element identical to a metal element applied to the conductor layer. The second seed layer may comprise one selected from the group consisting of copper, nickel, aluminum, gold, silver, and combinations thereof. The second seed layer may comprise copper.

A thickness of a first seed layer may be 25 nm to 250 nm. The thickness may be 50 nm or more. The thickness may be 75 nm or more. The thickness may be 90 nm or more. The thickness may be 100 nm or more. The thickness may be 230 nm or less. The thickness may be 200 nm or less.

A thickness of a second seed layer may be 25 nm to 250 nm. The thickness may be 50 nm or more. The thickness may be 75 nm or more. The thickness may be 90 nm or more. The thickness may be 100 nm or more. The thickness may be 230 nm or less. The thickness may be 200 nm or less.

In such a case, occurrence of plating defects that may occur during formation of the conductive layer 20 in the through via 11 may be effectively suppressed.

In such a case, occurrence of plating defects that may occur during formation of the electrically conductive layer 20 in the through via 11 may be effectively suppressed.

The conductor layer may comprise an electrically conductive material. The conductor layer may comprise one selected from the group consisting of copper, nickel, aluminum, gold, silver, and combinations thereof. The conductor layer may comprise copper.

The conductive layer 20 formed in contact with the via inner wall 13 may be formed to fill the entire through via 11. The conductive layer 20 formed in contact with the via inner wall 13 may be formed to surround an internal space in the through via 11.

Other Components in the Substrate

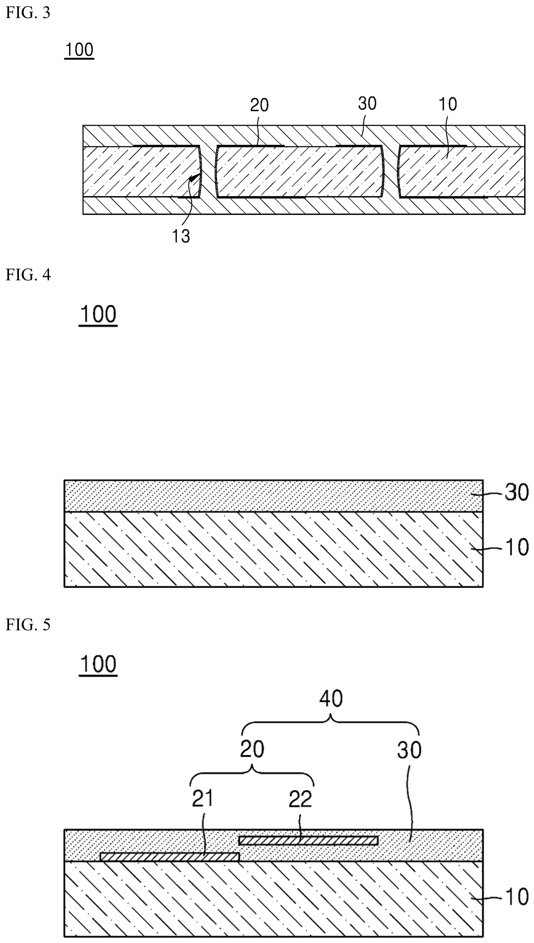

FIG. 3 is a cross-sectional view illustrating a substrate according to another embodiment of the present disclosure. Hereinafter, the present disclosure will be described with reference to FIG. 3.

The substrate 100 comprises a glass core 10. The glass core 10 comprises a through via 11 penetrating the glass core 10 in a thickness direction. For the components of the substrate 100, the same description as provided in FIGS. 1A, 1B, and 2 above is applied. The following description focuses on the differences.

The substrate 100 may comprise an insulating layer surrounding at least a portion of the conductive layer 20. When the conductive layer 20 is formed to surround an internal space of the through via 11, the insulating layer may be filled into the internal space. When the conductive layer 20 is disposed on the glass core 10, the insulating layer may be stacked on the conductive layer 20. When the conductive layer 20 is disposed under the glass core 10, the insulating layer may be stacked under the conductive layer 20.

The insulating layer 30 may provide insulation to a desired region within the substrate 100 and may stably support the conductive layer 20.

The substrate 100 may further comprise an insulating layer 30 disposed on the glass core 10. The insulating layer 30 may be disposed in contact with at least a portion of an upper surface of the glass core 10.

The insulating layer 30 may comprise an insulating resin. The insulating resin may provide insulating characteristics to the insulating layer 30.

A hydrophilicity index (Ih) of the insulating layer 30 represented by Equation 1 below may be 7 to 12.

[Equation 1]

$$Ih = \frac{Rc\,c}{Rc\,o}$$

In Equation 1, Rcc is an abundance ratio of carbon-carbon bonds to total carbon-element bonds, and Rco is an abundance ratio of carbon-oxygen bonds to total carbon-element bonds.

In Equation 1, the total carbon-element bonds mean bonds formed between carbon and carbon and between carbon and element other than carbon.

The present disclosure may control a ratio of the number of carbon-carbon single bonds to the number of carbon-oxygen single bonds in the insulating layer 30 to adjust hydrophobicity of the insulating layer 30. The insulating layer 30 having adjusted hydrophobicity may have a controlled affinity to moisture and may improve moisture resistance of the substrate 100.

The Rcc value and Rco value of the insulating layer 30 may be measured by XPS (X-ray Photoelectron Spectroscopy). Specifically, an area of 1 cm in width and 1 cm in length in the insulating layer 30 may be measured by an XPS microprobe in narrow scan mode. In the measurement, 15 scans, a beam size of 650 $\mu$m, a step of 0.05 eV, and a CAE 20 pass energy may be applied as measurement conditions. For example, ESCALAB of Thermo may be applied as the XPS microprobe.

The Ih value of the insulating layer 30 may be 7 to 12. The Ih value may be 7.5 or more. The Ih value may be 8 or more. The Ih value may be 8.5 or more. The Ih value may be 11 or less. In such a case, deterioration in durability of the insulating layer 30 due to humidity may be effectively suppressed.

The insulating layer 30 may comprise a filler. The filler may impart controlled thermal expansion properties and mechanical properties to the insulating layer 30. The filler may comprise silica. The filler may comprise silica and a metal oxide.

When silica is applied as a filler to the insulating layer 30, a part of silicon in the silica surface and carbon and/or oxygen in the insulating resin may form bonds. These bonds may affect the mechanical properties and moisture resistance of the insulating layer 30.

The present disclosure may control a moisture resistance index (Irw) of the insulating layer 30 represented by Equation 2 below within a predetermined range in the present disclosure.

$$[\text{Equation 2}]$$
$$\text{Irw} = \text{Rso}(\%) + \text{Rsc}(\%)$$

In Equation 2, Rso is an abundance ratio (%) of Si-O single bonds to total Si-element bonds, and Rsc is an abundance ratio (%) of Si-C single bonds to total Si-element bonds.

In Equation 2, the total Si-element bonds mean bonds formed between silicon and silicon and between silicon and element other than silicon.

Through this, it may be possible to suppress excessive brittleness of the insulating layer 30 caused by formation of an excessive number of bonds between the insulating resin and the filler. In addition, the extent to which interatomic bonds having relatively high hydrophilicity are formed in the insulating layer may be reduced to a certain level or less.

The Rso value and Rsc value of the insulating layer 30 may be measured by XPS. The measurement conditions of XPS may be applied as described above. Since the detailed contents on the measurement method of the Rso value and the Rsc value of the insulating layer 30 are identical to those described above, repeated descriptions are omitted. The Irw value may be calculated from the measured Rso value and Rsc value.

The Irw value of the insulating layer 30 may be 0.03% to 0.1 %. The Irw value may be 0.05% or more. The Irw value may be 0.07% or more. The Irw value may be 0.095% or less. In such a case, the insulating layer 30 may maintain flexibility suitable for the substrate 100 for a long time under a high-humidity environment.

An abundance ratio of carbon-carbon double bonds to total carbon-element bonds of the insulating layer 30 may be 12% to 17%.

The total carbon-element bonds mean bonds formed between carbon and carbon and between carbon and other elements.

In the case of the insulating layer 30 in which the abundance ratio of carbon-carbon double bonds to total carbon-element bonds is controlled, the insulating layer 30 may have improved durability and may stably support and fix the conductive layer disposed therein.

The abundance ratio of carbon-carbon double bonds to total carbon-element bonds of the insulating layer 30 may be measured by XPS. The abundance ratio of carbon-carbon double bonds to total carbon-element bonds may be measured by XPS under the same measurement conditions as described above. Since the description of the measurement conditions overlaps with the previous contents, repeated descriptions are omitted.

The abundance ratio of carbon-carbon double bonds to total carbon-element bonds of the insulating layer 30 may be 12% to 17%. The abundance ratio may be 13% or more. The abundance ratio may be 14% or more. The abundance ratio may be 16% or less. In such a case, the insulating layer 30 may effectively protect and support the conductive layer while having appropriate flexibility.

A moisture absorption rate of the substrate 100 measured after immersion in water at 23 °C for 24 hours may be 0.1% or less.

In the case of the substrate 100 in which the moisture absorption rate is controlled, degradation such as hydrolysis of the insulating layer 30 or the like caused by residual moisture in the substrate 100 may be effectively suppressed.

The moisture absorption rate of the substrate 100 is measured based on ASTM D570 standard. Specifically, the substrate 100 is cut into three samples, each having a size of 20 mm × 20 mm. Each sample is placed in an environmental chamber and left at an ambient temperature of 23 °C for 24 hours, and then the weight of the sample is measured. Thereafter, each sample is immersed in water at 23 °C for 24 hours, and the moisture on the surface of the substrate 100 is removed, and the weight of the sample is measured. A value obtained by subtracting the weight before immersion from the weight after immersion is divided by the weight before immersion, and the calculated value converted into a percentage is defined as the moisture absorption rate. The average value of the moisture absorption rates measured from the three samples is defined as the moisture absorption rate of the substrate 100. For example, Thermotron S-16 of Thermotron may be applied as the environmental chamber.

The moisture absorption rate of the substrate 100 measured after immersion in water at 23 °C for 24 hours may be 0.1% or less. The moisture absorption rate may be 0.09% or less. The moisture absorption rate may be 0.08% or less. The moisture absorption rate may be 0.01% or more. In such a case, a rate of deterioration in durability of the insulating layer 30 due to moisture may be effectively slowed down.

The present disclosure may control a tensile strength of the substrate 100 to a certain level or more. In such a case, when an external force is applied to the substrate 100 including the insulating layer 30 during a manufacturing or transfer process, the substrate 100 may not be easily damaged.

The tensile strength of the substrate 100 is measured as follows. The substrate 100 is processed into five samples, each having a size of 12.7 mm $\times$ 63.5 mm. Each sample is stabilized at 23 °C for 24 hours, and then the stabilized sample is fixed to a tensile strength tester and subjected to a tensile load at a speed of 5 mm/min until the sample is broken. The maximum tensile load and displacement of the sample at break are measured to calculate the tensile strength for each sample. The average value of the tensile strength values of the five samples is defined as the tensile strength of the substrate 100. For example, Instron 5982 of Instron may be applied as the tensile strength tester.

The tensile strength of the substrate 100 may be 60 MPa or more. The tensile strength may be 63 MPa or more. The tensile strength may be 65 MPa or more. The tensile strength may be 90 MPa or less. In such a case, the substrate 100 having excellent resistance to external impact may be provided.

The insulating layer 30 may include an insulating resin. The insulating resin may include an epoxy-based resin. The insulating resin may include a cured epoxy-based resin.

The insulating resin may include the epoxy-based resin in an amount of 70 wt% or more. The insulating resin may include the epoxy-based resin in an amount of 80 wt% or more. The insulating resin may include the epoxy-based resin in an amount of 90 wt% or more. The insulating resin may include the epoxy-based resin in an amount of 100 wt% or less.

In the present disclosure, the epoxy-based resin may include a first residue derived from a bisphenol-type epoxy-based resin and a second residue derived from a novolac-type epoxy-based resin. Specifically, by introducing the bisphenol-type epoxy-based resin, it may help densely form cross-linking bonds within the insulating layer 30. In addition, by introducing the novolac-type epoxy-based resin, it may increase a frequency of bond formation between the insulating resin and a filler surface and contribute to imparting stable thermal expansion characteristics to the insulating layer 30.

The bisphenol-type epoxy-based resin may include at least one of a bisphenol A-type epoxy-based resin or a bisphenol F-type epoxy-based resin. The bisphenol-type epoxy-based resin may be the bisphenol A-type epoxy-based resin.

The novolac-type epoxy-based resin may include at least one of a phenol-novolac-type epoxy-based resin or a cresol-novolac-type epoxy-based resin.

The epoxy-based resin may include the first residue in an amount of 50 wt% or more. The epoxy-based resin may include the first residue in an amount of 60 wt% or more. The epoxy-based resin may include the first residue in an amount of 90 wt% or less. In such a case, the insulating layer 30 may be imparted with excellent mechanical strength.

The epoxy-based resin may include the second residue in an amount of 5 wt% or more. The epoxy-based resin may include the second residue in an amount of 10 wt% or more. The epoxy-based resin may include the second residue in an amount of 15 wt% or more. The epoxy-based resin may include the second residue in an amount of 40 wt% or less. The epoxy-based resin may include the second residue in an amount of 35 wt% or less. The epoxy-based resin may include the second residue in an amount of 30 wt% or less. In such a case, during a manufacturing process, it may suppress damage to the glass core 10 due to excessive thermal expansion of the insulating layer 30.

The insulating layer 30 may include the epoxy-based resin in an amount of 50 wt% or more. The insulating layer 30 may include the epoxy-based resin in an amount of 55 wt% or more. The insulating layer 30 may include the epoxy-based resin in an amount of 60 wt% or more. The insulating layer 30 may include the epoxy-based resin in an amount of 65 wt% or less. The insulating layer 30 may include the epoxy-based resin in an amount of 100 wt% or less. The insulating layer 30 may include the epoxy-based resin in an amount of 95 wt% or less. The insulating layer 30 may include the epoxy-based resin in an amount of 90 wt% or less. In such a case, while suppressing excessive thermal expansion of the insulating layer 30 during a manufacturing process of the substrate 100, it may impart stable insulating characteristics to a region in which a conductive layer is disposed.

The insulating layer 30 may include a filler. The filler may include silica. The silica may form a bond with the insulating resin to help the insulating layer 30 have controlled thermal expansion characteristics.

The filler may further include a metal oxide. The metal oxide may be any one selected from the group consisting of barium sulfate, magnesium carbonate, calcium carbonate, aluminum oxide, aluminum hydroxide, aluminum nitride, titanium oxide, and combinations thereof.

In the present disclosure, silica and the metal oxide may be applied together as the filler. In such a case, a number of silicon-oxygen bonds within the insulating layer 30 may be controlled within a certain range. Through this, while suppressing an excessively increased hydrophilicity of the insulating layer 30, the insulating layer 30 may have stable thermal expansion characteristics.

The filler may include silica in an amount of 25 wt% or more. The filler may include silica in an amount of 30 wt% or more. The filler may include silica in an amount of 35 wt% or more. The filler may include silica in an amount of 55 wt% or less. The filler may include silica in an amount of 50 wt% or less.

The filler may include the metal oxide in an amount of 30 wt% or more. The filler may include the metal oxide in an amount of 40 wt% or more. The filler may include the metal oxide in an amount of 70 wt% or less. The filler may include the metal oxide in an amount of 60 wt% or less.

In such a case, while suppressing deterioration in moisture resistance of the insulating layer 30, excellent mechanical strength and controlled thermal expansion characteristics may be imparted to the insulating layer 30.

The filler may further include a filler other than silica and the metal oxide. By way of example, the filler may further include Dow Corning Z-6018, which is an organic silicon filler of Dow Corning.

The insulating layer 30 may include the filler in an amount of 12 wt% or more. The insulating layer 30 may include the filler in an amount of 15 wt% or more. The insulating layer 30 may include the filler in an amount of 30 wt% or less.

An average diameter of the filler may be 5 μm or less. The average diameter may be 4 μm or less. The average diameter may be 3 μm or less. The average diameter may be 2 μm or less. The average diameter may be 0.5 μm or more.

A maximum diameter of the filler may be 20 μm or less. The maximum diameter may be 17 μm or less. The maximum diameter may be 15 μm or less. The maximum diameter may be 12 μm or less. The maximum diameter may be 10 μm or less. The maximum diameter may be 5 μm or more.

In such a case, it may assist in precisely forming a fine wiring layer on the insulating layer 30, thereby stably securing electrical reliability of the substrate 100.

The insulating layer 30 may further include other additives in addition to the components described above. The additives are not limited as long as they are conventionally applied in the field of the substrate 100. By way of example, the additives may include a curing agent, a colorant, and a defoaming agent.

The substrate 100 may include a first redistribution layer disposed on the glass core 10. The first redistribution layer may include a conductive layer 20 and the insulating layer 30 surrounding at least a portion of the conductive layer 20.

The conductive layer 20 is a wire that transmits an electrical signal. The conductive layer 20 may be the conductive layer 20 described above.

A description of physical properties and composition of the insulating layer 30 is omitted because it is overlapping with the foregoing.

The first redistribution layer may be disposed in contact with an upper surface of the glass core 10. Another component may be disposed between the first redistribution layer and the upper surface of the glass core 10.

In the first redistribution layer, the insulating layer 30 and the conductive layer 20 may be mixedly disposed. The first redistribution layer may be formed in a structure in which the conductive layer 20 having a predetermined position and shape is embedded in the insulating layer 30. At least a portion of the conductive layer 20 in the first redistribution layer may be formed as a fine line. The first redistribution layer may be electrically connected to terminals or elements positioned on an upper portion of the substrate 100.

The conductive layer 20 may include a first conductive layer disposed in contact with the upper surface of the glass core 10. The insulating layer 30 may surround a portion of the first conductive layer. The insulating layer 30 may surround at least a portion of an upper surface of the first conductive layer. The insulating layer 30 may surround at least a portion of a side surface of the first conductive layer.

The conductive layer 20 may include a second conductive layer disposed on the glass core 10 but not in contact with the upper surface of the glass core 10. The insulating layer 30 may surround at least a portion of the second conductive layer. The insulating layer 30 may surround the entire second conductive layer.

A peel strength of the conductive layer 20 with respect to an upper surface of the insulating layer 30 may be 3 N/cm or more. The peel strength may be 3.5 N/cm or more. The peel strength may be 4 N/cm or more. The peel strength may be 10 N/cm or less. In such a case, the insulating layer 30 may stably support, protect, and insulate the conductive layer 20.

The peel strength of the conductive layer 20 with respect to the insulating layer 30 is measured by a bond tester according to a 180° peel test. A measurement speed (peeling speed) is 10 mm/s, a measurement distance (peeling distance) is 70 mm, and a measurement region is set to a region on the upper or lower surface of the glass core 10 where a through via is not formed. By way of example, the peel strength value may be measured using a Condor Sigma bond tester manufactured by XYZ TEC Co.

The substrate 100 may further include a second redistribution layer (not shown) disposed under the glass core 10.

The second redistribution layer may include a conductive layer and an insulating layer surrounding at least a portion of the conductive layer. The descriptions of the conductive layer and the insulating layer are omitted because they are overlapping with the foregoing.

In the second redistribution layer, the insulating layer and the conductive layer may be mixedly disposed. The second redistribution layer may be formed in a structure in which a conductive layer having a predetermined position and shape is embedded in the insulating layer 30. The second redistribution layer may be electrically connected to a terminal or a main board positioned on a lower portion of the substrate 100.

The substrate 100 may further include a bump (not shown) disposed below the second redistribution layer. The bump may be disposed in a predetermined shape under the glass core 10. For example, the bump may be disposed in a portion of a lower surface of the substrate 100 so as to be in contact with a main board or the like.

The substrate 100 may be used for a semiconductor package. The substrate 100 may be a packaging substrate for mounting and protecting a semiconductor element.

Substrate according to another embodiment of the present disclosure

FIG. 4 is a cross-sectional view illustrating a substrate 100 according to another embodiment of the present disclosure, and FIG. 5 is a cross-sectional view illustrating a substrate 100 according to another embodiment of the present disclosure. Hereinafter, the present disclosure will be described with reference to FIGS. 4 and 5.

The descriptions of the glass core 10, the insulating layer 30, and the conductive layer 20 described in FIGS. 1 to 3 are equally applicable to FIGS. 4 and 5.

The substrate according to another embodiment of the present disclosure includes a glass core and an insulating layer disposed on the glass core. A hydrophilicity index (Ih) of the insulating layer represented by Equation 1 may be 7 to 12. The substrate may further include a conductive layer. Physical properties, compositions, and structures of the glass core, the insulating layer, and the conductive layer may be the same as those of the glass core, the insulating layer, and the conductive layer described above. The descriptions of the glass core, the insulating layer, and the conductive layer are omitted because they are overlapping with the foregoing.

Semiconductor package

A semiconductor package according to another embodiment of the present disclosure includes a substrate and an element electrically connected to the substrate.

The substrate has a use for a semiconductor package and may be mounted on a main board to be electrically connected thereto.

The substrate and the element may be the same as those described above. The descriptions of the substrate and the element are omitted because they are overlapping with the foregoing.

Method for manufacturing substrate

A method for manufacturing a substrate according to another embodiment of the present disclosure includes a base glass plate forming step of preparing a base glass plate from a glass manufacturing composition, and a through via forming step of forming a through via in the base glass plate to prepare a glass core.

The glass manufacturing composition may include silicon dioxide in an amount of 50 wt% or more. The glass manufacturing composition may include silicon dioxide in an amount of 55 wt% or more. The glass manufacturing composition may include silicon dioxide in an amount of 60 wt% or more. The glass manufacturing composition may include silicon dioxide in an amount of 65 wt% or more. The glass manufacturing composition may include silicon dioxide in an amount of 90 wt% or less.

The glass manufacturing composition may include any one selected from the group consisting of sodium oxide, calcium oxide, potassium oxide, titanium oxide, boron oxide, and combinations thereof.

The glass manufacturing composition may include a fining agent. The fining agent may remove bubbles through a reduction reaction in molten glass. The fining agent is not limited as long as it is conventionally applied in the field of glass substrates. By way of example, the fining agent may include sodium sulfate, arsenic trioxide and nitrate thereof, antimony trioxide and nitrate thereof, ammonium nitrate, ammonium sulfate, and potassium nitrate.

The glass manufacturing composition may include the fining agent in an amount of 0.01 wt% or more. The glass manufacturing composition may include the fining agent in an amount of 0.03 wt% or more. The glass manufacturing composition may include the fining agent in an amount of 0.05 wt% or more. The glass manufacturing composition may include the fining agent in an amount of 3 wt% or less. The glass manufacturing composition may include the fining agent in an amount of 2 wt% or less. The glass manufacturing composition may include the fining agent in an amount of 1 wt% or less.

The glass manufacturing composition may further include an additive conventionally applied in the field of glass substrates. For example, the additive may be a coloring agent, a flux, a physical stabilizer, a chemical stabilizer, or a combination thereof.

The base glass plate forming step may include a melting process of melting the glass manufacturing composition to prepare molten glass, and a cooling process of cooling the molten glass to prepare a base glass plate.

During the melting process and the cooling process, bubbles in the base glass plate may be substantially removed through the fining agent applied to the glass manufacturing composition.

During the melting process, the glass manufacturing composition may be melted at 1000 °C or higher. During the melting process, the glass manufacturing composition may be melted at 1050 °C or higher. During the melting process, the glass manufacturing composition may be melted at 1100 °C or higher. During the melting process, the glass manufacturing composition may be melted at 1150 °C or higher. During the melting process, the glass manufacturing composition may be melted at 1200 °C or higher. During the melting process, the glass manufacturing composition may be melted at 2000 °C or lower.

The melting process may be performed for one hour or longer. The melting process may be performed for two hours or longer. The melting process may be performed for ten hours or less.

In such a case, the fining agent may be sufficiently reduced to facilitate smooth degassing of the molten glass.

The melting process may be performed with stirring of the glass manufacturing composition.

In the cooling process, a cooling rate may be 0.05 °C/min or more. The cooling rate may be 0.1 °C/min or more. The cooling rate may be 0.3 °C/min or more. The cooling rate may be 10 °C/min or less. The cooling rate may be 7 °C/min or less. The cooling rate may be 5 °C/min or less.

In such a case, a reduction reaction product derived from the fining agent may sufficiently react with and be dissolved in residual oxygen in the molten glass, thereby effectively suppressing bubble formation caused by oxygen or the fining agent.

If necessary, the base glass plate may be annealed to stably control mechanical properties of the base glass plate. The annealing of the base glass plate may be performed at an ambient temperature of 700 °C or higher, 800 °C or higher, 900 °C or higher, 1000 °C or higher, or 2000 °C or lower. The annealing of the base glass plate may be performed for five hours or longer, eight hours or longer, ten hours or longer, twelve hours or longer, or fifty hours or less, forty hours or less, or thirty hours or less.

In the through via forming step, the through via described above may be formed in the base glass plate. A description of the through via is omitted because it is overlapping with the foregoing.

In the through via forming step, a defect may be formed in a region of the base glass plate where the through via is to be formed. Specifically, a defect may be formed by irradiating a laser to the region of the base glass plate where the through via is to be formed.

When forming the defect, a laser may be irradiated through a laser irradiation device. A focus size applied when forming the defect may be 5 $\mu$m to 50 $\mu$m. A wavelength of the laser irradiated when forming the defect may be 200 nm to 500 nm. The laser may be irradiated for 5 seconds to 30 seconds when forming the defect. For example, a laser irradiation device such as the VYPER model manufactured by Coherent Corp. may be applied.

The base glass plate having completed the defect formation may be immersed in an acidic solution, and a through via may be formed by performing ultrasonic treatment on the acidic solution.

In the through via forming step, after immersing the base glass plate in the acidic solution, ultrasonic vibration may be applied to the acidic solution. Through this, etching by the acidic solution may occur in a region where the through via is to be formed, thereby precisely forming the through via having a fine diameter.

The acidic solution may be prepared by dissolving an acid component in deionized water as a solvent. The acid component may be any one selected from the group consisting of hydrofluoric acid, nitric acid, hydrochloric acid, sulfuric acid, hydrobromic acid, hydroiodic acid, perchloric acid, chloric acid, and combinations thereof.

The through via forming step may be performed by placing the base glass plate in an acidic solution containing hydrofluoric acid and/or nitric acid, and applying ultrasonic treatment thereto. At this time, a concentration of the hydrofluoric acid may be 0.5 M or more, or 1.1 M or more. The concentration of the hydrofluoric acid may be 3 M or less, or 2 M or less. The concentration of the nitric acid may be 0.5 M or more, or 1 M or more, or 2 M or less.

During the ultrasonic treatment, the ultrasonic frequency may be 40 Hz to 120 Hz, or 60 Hz to 100 Hz. The ultrasonic treatment may be performed at a power output of 80% or higher, 90% or higher, or 100%.

The ultrasonic treatment may be performed for 30 seconds or longer, 1 minute or longer, or 3 minutes or longer, or may be performed for 30 minutes or less, 20 minutes or less, or 10 minutes or less. In such a case, the through via may be formed in a desired region without excessive surface damage to the glass core.

The glass core and the through via formed through the through via forming step may be the same as the glass core and the through via described above. The descriptions of the glass core and the through via are omitted because they are overlapping with the foregoing.

If necessary, a rinsing process for rinsing the prepared glass core may be further included. In the rinsing process, an acidic solution remaining on the surface of the glass core may be removed to suppress excessive surface damage to the glass core. In the rinsing process, the surface of the glass core may be rinsed with ultrapure water.

The method for manufacturing the substrate may form a conductive layer on the glass core in which the through via is formed. The conductive layer may be formed on a via inner wall within the through via. The conductive layer may be formed on an upper surface of the glass core. The conductive layer may be formed on a lower surface of the glass core.

The conductive layer may be formed by a dry method or a wet method.

The dry method is a method of forming a seed layer by performing sputtering on a region where the conductive layer is to be disposed, and forming the conductive layer by performing plating on a region where the seed layer is formed. When forming the seed layer, a metal such as titanium, chromium, or nickel may be sputtered, or sputtering may be performed by applying copper together with the metals. Through sputtering, an anchor effect in which metal particles interact with a surface of the glass core or an insulating layer may appear, thereby improving adhesion of the conductive layer.

The wet method is a method of performing metal plating after treating a primer in a portion where formation of the conductive layer is necessary. The primer may include a compound having a functional group such as an amine group. Depending on a degree of desired adhesion, the primer may include a compound having a functional group such as an amine group and a silane coupling agent together. When the silane coupling agent is applied, a primer layer may be formed by performing a pretreatment with the silane coupling agent on a surface to be treated with the primer, and then coating the pretreated region with a compound having an amine group.

A thickness of the seed layer may be 50 nm to 500 nm. The thickness may be 100 nm or more. The thickness may be 150 nm or more. The thickness may be 180 nm or more. The thickness may be 200 nm or more. The thickness may be 450 nm or less. The thickness may be 400 nm or less.

A thickness of a first seed layer may be 25 nm to 250 nm. The thickness may be 50 nm or more. The thickness may be 75 nm or more. The thickness may be 90 nm or more. The thickness may be 100 nm or more. The thickness may be 230 nm or less. The thickness may be 200 nm or less.

A thickness of a second seed layer may be 25 nm to 250 nm. The thickness may be 50 nm or more. The thickness may be 75 nm or more. The thickness may be 90 nm or more. The thickness may be 100 nm or more. The thickness may be 230 nm or less. The thickness may be 200 nm or less.

In such a case, when forming a conductor layer on the seed layer, plating defects may be effectively suppressed.

After forming the seed layer or the primer layer, a metal may be plated to form the conductor layer. When forming the conductor layer, copper plating may be applied, but the present disclosure is not limited thereto. Before metal plating, a portion of the seed layer or the primer layer where formation of the conductive layer is unnecessary may be deactivated, or a portion where formation of the conductive layer is necessary may be activated, and then plating may be performed. As a method for activation or deactivation treatment, light irradiation treatment such as irradiating a laser of a specific wavelength, or chemical treatment may be applied. However, even when activation or deactivation treatment is not applied, metal plating may be performed, and then the conductive layer may be etched and patterned according to a pre-designed shape.

After forming the conductive layer, an insulating layer surrounding the conductive layer may be formed. Before forming the insulating layer on the glass core, the upper surface of the glass core may be plasma-treated. Through this, an adhesion force between the insulating layer and the upper surface of the glass core may be further improved.

The insulating layer may be prepared by laminating a film for forming an insulating layer on the glass core and curing the film, or by coating a composition for forming an insulating layer on the glass core and curing the compostion. When an internal space is formed within the through via, during a process in which the film for forming the insulating layer is cured, the film for forming the insulating layer may be filled into the internal space within the through via and then cured.

The film for forming the insulating layer may include an epoxy-based resin and a filler. The film for forming the insulating layer may include an epoxy-based resin before being cured and a filler.

The epoxy-based resin may include a bisphenol-type epoxy-based resin and a novolac-type epoxy-based resin. The bisphenol-type epoxy-based resin may include at least one of a bisphenol A-type epoxy-based resin or a bisphenol F-type epoxy-based resin. The bisphenol-type epoxy-based resin may be the bisphenol A-type epoxy-based resin. The novolac-type epoxy-based resin may include at least one of a phenol-novolac-type epoxy-based resin or a cresol-novolac-type epoxy-based resin.

The epoxy-based resin may include the bisphenol-type epoxy-based resin in an amount of 50 wt% or more. The epoxy-based resin may include the bisphenol-type epoxy-based resin in an amount of 60 wt% or more. The epoxy-based resin may include the bisphenol-type epoxy-based resin in an amount of 90 wt% or less.

The epoxy-based resin may include the novolac-type epoxy-based resin in an amount of 5 wt% or more. The epoxy-based resin may include the novolac-type epoxy-based resin in an amount of 10 wt% or more. The epoxy-based resin may include the novolac-type epoxy-based resin in an amount of 15 wt% or more. The epoxy-based resin may include the novolac-type epoxy-based resin in an amount of 40 wt% or less. The epoxy-based resin may include the novolac-type epoxy-based resin in an amount of 35 wt% or less. The epoxy-based resin may include the novolac-type epoxy-based resin in an amount of 30 wt% or less.

In such a case, it may help form an insulating layer having improved mechanical strength and moisture resistance.

The film for forming the insulating layer may include the epoxy-based resin in an amount of 10 wt% or more. The film for forming the insulating layer may include the epoxy-based resin in an amount of 15 wt% or more. The film for forming the insulating layer may include the epoxy-based resin in an amount of 20 wt% or more. The film for forming the insulating layer may include the epoxy-based resin in an amount of 35 wt% or less. The film for forming the insulating layer may include the epoxy-based resin in an amount of 32 wt% or less. The film for forming the insulating layer may include the epoxy-based resin in an amount of 29 wt% or less. The film for forming the insulating layer may include the epoxy-based resin in an amount of 25 wt% or less.

The film for forming the insulating layer may further include an additive conventionally applied in the field of build-up films. The additive may include, for example, a curing agent, a colorant, and a defoaming agent.

The film for forming the insulating layer laminated on the glass core may be cured to form the insulating layer. The film for forming the insulating layer may be disposed in contact with a portion of the upper surface of the glass core. The film for forming the insulating layer may be disposed in contact with an upper surface of a first conductive layer disposed on the glass core.

Curing may be performed through two or more processes including a lamination process and a curing process.

In the lamination process, a vacuum atmosphere may be formed, and after placing a film for forming an insulating layer in a target region for forming the insulating layer, pressure may be applied to the film to laminate it.

In the lamination process, a vacuum pressure may be 2 hPa or more. The vacuum pressure may be 3 hPa or more. The vacuum pressure may be 10 hPa or less.

An ambient temperature of the lamination process may be 50 °C or higher. The ambient temperature may be 60 °C or higher. The ambient temperature may be 100 °C or lower. The ambient temperature may be 90 °C or lower.

A pressure applied during lamination of the film for forming the insulating layer may be 0.2 MPa or more. The pressure may be 0.3 MPa or more. The pressure may be 1 MPa or less.

A time during which pressure is applied during lamination of the film for forming the insulating layer may be 10 seconds or more. The time may be 20 seconds or more. The time may be 90 seconds or less.

During the lamination process, the laminated film for forming the insulating layer may be additionally pressed.

When pressing the laminated film for forming the insulating layer, the applied pressure may be 0.2 MPa or more. The pressure may be 0.3 MPa or more. The pressure may be 1 MPa or less.

A time during which pressure is applied during lamination of the film for forming the insulating layer may be 10 seconds or more. The time may be 20 seconds or more. The time may be 90 seconds or less.

In the curing process, the laminated film for forming the insulating layer may be cured to form the insulating layer.

An ambient temperature in the curing process may be 120 °C or higher. The ambient temperature may be 140 °C or higher. The ambient temperature may be 160 °C or higher. The ambient temperature may be 250 °C or lower.

The curing process may be performed for 10 minutes or longer. The curing process may be performed for 15 minutes or longer. The curing process may be performed for 20 minutes or longer. The curing process may be performed for 60 minutes or less.

The composition for forming an insulating layer may include an epoxy-based resin in an amount of 50 wt% or more. The composition for forming an insulating layer may include an epoxy-based resin in an amount of 55 wt% or more. The composition for forming an insulating layer may include an epoxy-based resin in an amount of 60 wt% or more. The composition for forming an insulating layer may include an epoxy-based resin in an amount of 65 wt% or more. The composition for forming an insulating layer may include an epoxy-based resin in an amount of 100 wt% or less. The composition for forming an insulating layer may include an epoxy-based resin in an amount of 95 wt% or less. The composition for forming an insulating layer may include an epoxy-based resin in an amount of 90 wt% or less.

The composition for forming an insulating layer may further include a curing agent. The curing agent may form a cured epoxy-based resin through a cross-linking reaction with the epoxy-based resin. The curing agent is not limited as long as it is conventionally applied to epoxy-based resins. For example, the curing agent may be a polyamine curing agent Ancamine 2422 manufactured by Evonik.

The composition for forming an insulating layer may further include a filler. As the filler, the filler described above may be applied. A description of the filler is omitted because it is overlapping with the foregoing.

The composition for forming an insulating layer may include the filler in an amount of 12 wt% or more. The composition for forming an insulating layer may include the filler in an amount of 15 wt% or more. The composition for forming an insulating layer may include the filler in an amount of 30 wt% or less. In such a case, it may help form an insulating layer having strength and thermal expansion characteristics suitable for application to a packaging substrate.

The composition for forming an insulating layer may further include an additive conventionally applied in the field of build-up films. The additive may include, for example, a curing agent, a colorant, and a defoaming agent.

Immediately after coating the composition for forming an insulating layer on the glass core, the composition may be pre-heat-treated to perform partial curing of the composition.

During the pre-heat treatment, a heat treatment temperature may be 40 °C or higher. The heat treatment temperature may be 50 °C or higher. The heat treatment temperature may be 100 °C or lower. The heat treatment temperature may be 90 °C or lower.

During the pre-heat treatment, a heat treatment time may be 1 minute or longer. The heat treatment time may be 3 minutes or longer. The heat treatment time may be 5 minutes or longer. The heat treatment time may be 30 minutes or less. The heat treatment time may be 20 minutes or less.

The composition for forming an insulating layer formed on the glass core may be cured to form the insulating layer. At least a portion of the composition for forming an insulating layer may be disposed in contact with an upper surface of the glass core. At least a portion of the composition for forming an insulating layer may be disposed in contact with an upper surface of a conductive layer disposed on the glass core.

Curing may be performed through two or more processes including a primary curing process and a secondary curing process.

In the primary curing process, the composition (or film) for forming the insulating layer formed on the upper surface of the glass core may be heat-treated.

A heat treatment temperature of the primary curing process may be 40 °C or higher. The heat treatment temperature may be 50 °C or higher. The heat treatment temperature may be 100 °C or lower. The heat treatment temperature may be 90 °C or lower.

A heat treatment time of the primary curing process may be 30 minutes or longer. The heat treatment time may be 40 minutes or longer. The heat treatment time may be 3 hours or less. The heat treatment time may be 2 hours or less.

In such a case, bonding between the insulating resin and the filler within the composition for forming an insulating layer may be stably formed.

In the secondary curing process, the composition for forming an insulating layer having completed the primary curing process may be heat-treated to form the insulating layer.

A heat treatment temperature of the secondary curing process may be 100 °C or higher. The heat treatment temperature may be 120 °C or higher. The heat treatment temperature may be 250 °C or lower. The heat treatment temperature may be 200 °C or lower.

A heat treatment time of the secondary curing process may be 45 minutes or longer. The heat treatment time may be 1 hour or longer. The heat treatment time may be 5 hours or less. The heat treatment time may be 3 hours or less.

In such a case, cross-linking bonds within the composition for forming an insulating layer may be smoothly formed.

The method for manufacturing the substrate may cool the substrate after completing the secondary curing process. During cooling, a controlled cooling rate may be applied to an ambient temperature in which the substrate is placed. Through this, damage to the substrate due to rapid thermal contraction may be suppressed.

A cooling rate may be 0.1 °C/min or more. The cooling rate may be 0.2 °C/min or more. The cooling rate may be 0.3 °C/min or more. The cooling rate may be 3 °C/min or less. The cooling rate may be 2 °C/min or less. The cooling rate may be 1 °C/min or less.

If necessary, after forming a conductive layer on the formed insulating layer, another insulating layer may be formed on the conductive layer so as to surround the conductive layer, thereby forming a first redistribution layer. The conductive layer and the insulating layer may be formed by the method described above. By repeatedly forming the conductive layer and the insulating layer on the formed insulating layer as described above, redistribution layers may be implemented in the substrate.

The method for manufacturing a substrate of the present disclosure may further include a process of forming a connection a terminal, a bump, or a cover layer on an upper surface and/or a lower surface of the substrate, or a process of mounting an element on the substrate.

Hereinafter, the present disclosure will be described in more detail through specific examples. The following examples are merely for facilitating understanding of the present disclosure, and the scope of the present disclosure is not limited thereto.

**Preparation Example: Manufacture of substrate**

Example 1-1: A glass manufacturing composition including 97 g of $SiO_2$ and 0.89 g of sodium sulfate ($Na_2SO_4$) and 0.53 g of sodium nitrate ($NaNO_3$) as fining agents was prepared in powder form. After mixing the glass manufacturing composition using a ball mill for five hours, the mixture was placed in a platinum crucible and melted at 1450 °C for three hours while stirring to prepare molten glass. The molten glass was poured into a mold of 1 cm width × 1 cm length × 2 mm depth and cooled at a cooling rate of 1 °C/min to prepare a base glass plate. The base glass plate was annealed at a heat treatment temperature of 1200 °C for 20 hours, then cooled at a rate of 5 °C/hour until the ambient temperature reached 500 °C, and naturally cooled until the ambient temperature reached room temperature.

A laser was irradiated to a region for forming through vias in the base glass plate using a laser irradiation device VYPER manufactured by Coherent Corp. to form defects. During defect formation, a focus size of 5 $\mu$m to 50 $\mu$m, a laser wavelength of 200 nm to 500 nm, and an irradiation time of 5 seconds to 30 seconds were applied.

After the defect formation, the base glass plate was immersed in an acidic solution including ultrapure water as a solvent and containing 2 M of hydrofluoric acid and 1.1 M of nitric acid, thereby forming through vias and completing the substrate manufacture.

Example 1-2: A conductive layer was formed on the via inner wall, upper surface, and lower surface within the substrate of Example 1. Specifically, a first seed layer of a titanium layer having a thickness of 150 nm was formed through sputtering, and a second seed layer of a copper layer having a thickness of 150 nm was formed on the first seed layer through sputtering. A conductor layer of a copper layer having a thickness of 30 $\mu$m was formed on the second seed layer through an electroless plating process. A dry film was laminated on the upper and lower surfaces of the substrate on which the conductive layer was formed, and a pattern was developed in the dry film. Thereafter, the conductive layer was dry-etched according to the pattern shape, and the dry film was removed to complete the conductive layer.

Example 2-1: 80 g of bisphenol A-type epoxy resin EPON 828 manufactured by Olin Corporation and 20 g of novolac-type epoxy resin EPN 1138 manufactured by Hexion Inc. as a liquid epoxy resin, and 30 g of polyamine curing agent Ancamine 2422 manufactured by Evonik were mixed at a speed of 200 rpm for 30 minutes under vacuum using a stirrer. Into the mixed composition, 30 g of filler (12 g of silica, 8 g of alumina, and 10 g of Dow Corning Z-6018, which is an organic silicon filler manufactured by Dow Corning) were added and further mixed at a speed of 150 rpm for 10 minutes. The composition mixed with the filler was defoamed for 20 minutes to prepare a composition for forming an insulating layer.

An upper surface of a glass substrate having a width of 100 mm and a length of 100 mm as a core layer was plasma-treated for five minutes, and the composition for forming an insulating layer was coated on the upper surface to a thickness of 5 $\mu$m. The coated composition was heat-treated at 60 °C for 10 minutes to form a layer of the composition for forming an insulating layer.

In the same manner as above, six layers of the composition for forming an insulating layer were formed on the upper side of the core layer, and three layers of the composition for forming an insulating layer were formed on the lower side of the core layer.

Thereafter, the substrate in which layers of the composition for forming an insulating layer were formed on the upper and lower sides of the core layer was placed in a heat treatment chamber, heat-treated at 60 °C for one hour, and further heat-treated at 150 °C for two hours to form an insulating layer. After completing the heat treatment, a cooling rate of 0.5 °C/min was applied to lower the ambient temperature to 25 °C to complete the substrate.

Example 2-2: Except that 27 g of filler (11 g of silica, 7 g of alumina, and 9 g of the organic silicon filler) were applied to the composition for forming an insulating layer, a substrate was manufactured in the same manner as in Example 2-1.

Example 2-3: Except that 26 g of filler (10 g of silica, 8 g of alumina, and 9 g of the organic silicon filler) were applied to the composition for forming an insulating layer, a substrate was manufactured in the same manner as in Example 2-1.

Comparative Example 2-1: Except that 20 g of the polyamine curing agent were applied to the composition for forming an insulating layer and 22 g of filler (5 g of silica, 7 g of alumina, and 10 g of the organic silicon filler) were applied, a substrate was manufactured in the same manner as in Example 2-1.

Comparative Example 2-2: Except that 40 g of the polyamine curing agent were applied to the composition for forming an insulating layer and 17 g of filler (10 g of silica and 7 g of alumina) were applied, a substrate was manufactured in the same manner as in Example 2-1.

Comparative Example 2-3: Except that 25 g of the polyamine curing agent were applied to the composition for forming an insulating layer and 19 g of filler (8 g of silica, 6 g of alumina, and 5 g of the organic silicon filler) were applied, a substrate was manufactured in the same manner as in Example 2-1.

### Evaluation Example: Measurement of element content by XPS

The substrate of Example 1-1 was cut into a size of 1 cm × 1 cm to prepare a sample. In the insulating layer within the sample, element contents in the substrate were measured in a narrow scan mode through the XPS microprobe ESCALAB manufactured by Thermo. During XPS measurement, measurement conditions were applied as 15 scans, a beam size of 650 $\mu$m, a step of 0.05 eV, and a pass energy of CAE 20.

From the elements detected by XPS, the content value of each element was converted so that the sum of the contents of the elements except carbon became 100 atomic %.

The converted value of Example 1-1 was described in Table 1 below.

### Evaluation Example: Measurement of the angle of via inner wall

A cross-sectional image in a thickness direction of the substrate of Example 1-1 was measured by TEM (Transmission Electron Microscope). From the cross-sectional image, an angle A1 formed between a via inner wall connecting a minimum inner diameter portion and a first opening and a vertical line to the upper surface of the substrate, and an angle A2 formed between a via inner wall connecting the minimum inner diameter portion and a second opening and a vertical line to the lower surface of the substrate were measured.

The measured values of Example 1-1 were described in Table 2 below.

**Evaluation Example: Evaluation of occurrence of defects in the conductive layer within the through via**

A cross-sectional image in the thickness direction of the substrate of Example 1-2 was measured by a TEM (Transmission Electron Microscope). In the cross-sectional image, when the conductive layer formed within the through via was observed to be entirely in close contact with the via inner wall and no disconnection of the conductive layer was found, it was evaluated as Pass. When at least a portion of the conductive layer was detached from the via inner wall or any disconnection of the conductive layer was found, it was evaluated as Fail.

The evaluation results of Example 1-2 were described in Table 2 below.

**Evaluation Example: Measurement of bond numbers between elements in the insulating layer through XPS**

Samples were prepared by cutting the substrates of Examples 2-1 to 2-3 and Comparative Examples 2-1 to 2-3 into a size of 1 cm $\times$ 1 cm. In the insulating layer of each sample, the values of Rcc and Rco of Equation 1, Rso and Rsc of Equation 2, and the abundance ratio of carbon-carbon double bonds to total carbon-element bonds were measured in a narrow scan mode through the XPS microprobe ESCALAB manufactured by Thermo. During XPS measurement, the measurement conditions were applied as 15 scans, a beam size of 650 $\mu$m, a step of 0.05 eV, and a pass energy of CAE 20.

From the measured Rec and Rco values, the Ih value of Equation 1 was calculated, and from the measured Rso and Rsc values, the Irw value of Equation 2 was calculated.

The measured and calculated values for each Example and Comparative Example were described in Table 3 below.

**Evaluation Example: Measurement of moisture absorption rate of the substrate**

Samples were prepared by cutting the substrates of Examples 2-1 to 2-3 and Comparative Examples 2-1 to 2-3 into sizes of 20 mm $\times$ 20 mm, and three samples were prepared for each. The moisture absorption rate of each sample was measured according to ASTM D570. Specifically, the samples were placed in an environmental chamber (Thermotron S-16 manufactured by Thermotron) and kept at an ambient temperature of 23 °C and a relative humidity of 50 RH %. After leaving the samples under those conditions, the weight of each sample was measured. Then, each sample was immersed in water at an ambient temperature of 23 °C for 24 hours, and after removing the moisture attached to the surface of each sample, the weight was measured again. The value obtained by dividing the difference between the weight after immersion and the weight before immersion by the mass before immersion was converted into a percentage and recorded as the moisture absorption rate.

For each Example and Comparative Example, the average value of the moisture absorption rates of the three samples was taken as the moisture absorption rate of that Example or Comparative Example.

The calculated values for each Example and Comparative Example were described in Table 3 below.

**Evaluation Example: Measurement of tensile strength of the packaging substrate**

Samples were prepared by cutting the substrates of Examples 2-1 to 2-3 and Comparative Examples 2-1 to 2-3 into sizes of 12.7 mm $\times$ 63.5 mm, and a total of five samples were prepared. Each sample was stabilized at 23 °C for 24 hours, and the stabilized samples were fixed on a tensile tester (Instron 5982 manufactured by Instron Co.) and subjected to a tensile load at a speed of 5 mm/min until the samples were broken. The maximum tensile load and deformation amount at the time of fracture of the samples were measured to calculate the tensile strength.

The average value of the tensile strength values of the five samples for each Example and Comparative Example was set as the tensile strength of the respective Example and Comparative Example.

The calculated values for each Example and Comparative Example were described in Table 3 below.

**Evaluation Example: Evaluation of insulating properties of the insulating layer**

The substrates of Examples 2-1 to 2-3 and Comparative Examples 2-1 to 2-3 were left at 100 °C for 1 hour or more and then cooled to room temperature. The resistance of the insulating layer in each packaging substrate was measured using a high-resistance meter (B2987A manufactured by Agilent). Specifically, electrodes were installed on the surface of the insulating layer, and a DC voltage of 500 V was applied for 1 minute. Immediately after 1 minute from the application of the voltage, the resistance of the insulating layer was measured. During resistance measurement, the ambient temperature was set to 25 °C and the ambient humidity to 50 RH %.

For each substrate, the resistance was measured three times, and the average value of the resistance values was calculated. When the calculated value was 100 M$\Omega$ or more, it was evaluated as Pass; when the calculated value was less than 100 M$\Omega$, it was evaluated as Fail.

The evaluation results for each Example and Comparative Example were described in Table 3 below.

**Evaluation Example: Evaluation of thermal stability of the insulating layer**

15 mg of the insulating layer was taken from the substrates of Examples 2-1 to 2-3 and Comparative Examples 2-1 to 2-3 as samples. The decomposition start temperature of each sample was measured by a thermogravimetric analyzer (TGA Q500 manufactured by TA Instruments). The decomposition start temperature was measured under a nitrogen atmosphere, and the nitrogen flow rate supplied to the atmosphere was set to 50 mL/min. The temperature rising rate was set to 10 °C/min, and the ambient temperature was raised to 500 °C. The ambient temperature at which the weight of the sample was reduced by 5 % was set as the decomposition start temperature.

When the decomposition start temperature was 410 °C or higher, it was evaluated as Pass, and when the decomposition start temperature was lower than 410 °C, it was evaluated as Fail.

The evaluation results for each Example and Comparative Example were described in Table 3 below.

[Table 1]

|  | Oxygen Content (atomic %) | Nitrogen Content (atomic %) | Sulfur Content (atomic %) | Silicon Content (atomic %) | Copper Content (atomic %) |
|---|---|---|---|---|---|
| Example 1-1 | 66.8 | 2.7 | 1.7 | 27.6 | 1.2 |
| Example 1-2 | - | - | - | - | - |

[Table 2]

|  | A1 | A2 | Evaluation of Defect Occurrence |
|---|---|---|---|
| Example 1-1 | 4.5 | 5.1 | - |
| Example 1-2 | - | - | Pass |

[Table 3]

|  | Ih | Irw (%) | Abundance Ratio of Carbon-Carbon Double Bonds to Total Carbon-Element Bonds (%) | Moisture Absorption Rate (%) | Tensile Strength (MPa) | Evaluation of Insulating Property | Evaluation of Thermal Stability |
|---|---|---|---|---|---|---|---|
| Example 2-1 | 9.1 | 0.09 | 14.63 | 0.07 | 68.3 | Pass | Pass |
| Example 2-2 | 9.2 | 0.07 | 14.50 | 0.08 | 66.7 | Pass | Pass |
| Example 2-3 | 9.5 | 0.08 | 14.90 | 0.09 | 65.9 | Pass | Pass |
| Comparative Example 2-1 | 9.1 | 0.02 | 14.63 | 0.13 | 58.5 | Fail | Fail |
| Comparative Example 2-2 | 9.1 | 0.09 | 10 | 0.11 | 45.2 | Fail | Fail |
| Comparative Example 2-3 | 5 | 0.09 | 14.63 | 0.10 | 52.1 | Fail | Fail |

In Table 3, the substrates of Examples 2-1 to 2-3 showed a moisture absorption rate of 0.09 % or less, whereas the substrates of Comparative Examples 2-1 to 2-3 showed a moisture absorption rate of 0.10 % or more. Regarding the tensile strength, the substrates of Examples 2-1 to 2-3 exhibited 60 MPa or higher, whereas the substrates of Comparative Examples 2-1 to 2-3 exhibited less than 60 MPa. In the evaluations of the insulating property and thermal stability, the substrates of Examples 2-1 to 2-3 were evaluated as Pass, whereas the substrates of Comparative Examples 2-1 to 2-3 were evaluated as Fail.

These results are considered to support that, in the Examples where the number of element bonds in the insulating layer was controlled within the range set in the present disclosure, the substrates may have superior moisture resistance and mechanical strength compared to the Comparative Examples.

The preferred embodiments of the present disclosure have been described in detail above. However, the scope of the present disclosure is not limited thereto, and various modifications and improvements using the basic concept of the present disclosure defined in the following claims by those skilled in the art also fall within the scope of the present disclosure.

[Description of Reference Numerals]

100: substrate
10: glass core
101: upper surface of glass core
102: lower surface of glass core
11: through via
12: internal space
13: via inner wall
14: first opening
15: second opening
16: minimum inner diameter portion
20: conductive layer
21: first conductive layer
22: second conductive layer
30: insulating layer
40: first redistribution layer

**Claims**

1. A substrate comprising:

   a glass core,
   wherein the glass core comprises a through via penetrating the glass core in a thickness direction,
   wherein a diameter of the through via is 50 $\mu$m to 100 $\mu$m, and
   wherein a sum of a sulfur content (atomic %) and a nitrogen content (atomic %) of the glass core is 0.2 atomic % to 8 atomic %.

2. The substrate of claim 1,
   wherein the glass core comprises 0.1 atomic % to 3 atomic % of sulfur.

3. The substrate of claim 1,
   wherein the glass core comprises 0.1 atomic % to 5 atomic % of nitrogen.

4. The substrate of claim 1,

   wherein the glass core comprises an upper surface and a lower surface facing the upper surface,
   wherein the through via has a diameter varying along the thickness direction of the substrate, and
   wherein the through via comprises a first opening in contact with the upper surface of the glass core, a second opening in contact with the lower surface of the glass core, and a minimum inner diameter portion having a smallest diameter and connecting the first opening and the second opening.

5. The substrate of claim 4,

   wherein the through via comprises an internal space and a via inner wall surrounding the internal space, and when observed in a cross-section in the thickness direction of the glass core, an angle formed between the via inner wall connecting the minimum inner diameter portion and the first opening and a vertical line to the upper surface of the glass core is 0.1° to 8°.

6. The substrate of claim 1,

   wherein the through via comprises an internal space and a via inner wall surrounding the internal space,

wherein the substrate further comprises a conductive layer formed on the via inner wall,
wherein the conductive layer comprises a seed layer and a conductor layer disposed on the seed layer, and
wherein a thickness of the seed layer is 50 nm to 500 nm.

7. The substrate of claim 1,

further comprising an insulating layer disposed on the glass core,
wherein the insulating layer comprises an insulating resin,
and a hydrophilicity index (Ih) of the insulating layer represented by Equation 1 below is 7 to 12:

[Equation 1]

$$Ih = \frac{Rc\,c}{Rc\,o}$$

wherein Rcc is an abundance ratio of carbon-carbon bonds to total carbon-element bonds, and Rco is an abundance ratio of carbon-oxygen bonds to total carbon-element bonds.

8. The substrate of claim 7,

wherein the insulating layer further comprises a filler,
wherein the filler comprises silica,
and a moisture resistance index (Irw) of the insulating layer represented by Equation 2 below is 0.03 % to 0.1 %:

[Equation 2]

$$Irw = Rso(\%) + Rsc(\%)$$

wherein Rso is an abundance ratio (%) of Si-O single bonds to total Si-element bonds, and Rsc is an abundance ratio (%) of Si-C single bonds to total Si-element bonds.

9. The substrate of claim 7,
wherein an abundance ratio of carbon-carbon double bonds to total carbon-element bonds of the insulating layer is 12 % to 17 %.

10. The substrate of claim 7,
wherein a moisture absorption rate measured after immersion in water at 23 °C for 24 hours is 0.1 % or less.

11. The substrate of claim 7,
wherein a tensile strength is 60 MPa or more.

12. The substrate of claim 8,

wherein the filler further comprises a metal oxide, and
wherein the filler comprises 30 wt % to 70 wt % of the metal oxide.

13. The substrate of claim 7,

wherein the insulating resin comprises an epoxy-based resin, and
wherein the epoxy-based resin comprises a first residue derived from a bisphenol-type epoxy-based resin and a second residue derived from a novolac-type epoxy-based resin.

14. The substrate of claim 1,
wherein the substrate is for use in a semiconductor package.

15. A substrate comprising:

a glass core; and

an insulating layer disposed on the glass core,
wherein the insulating layer comprises an insulating resin,
and a hydrophilicity index (Ih) of the insulating layer represented by Equation 1 below is 7 to 12:

[Equation 1]

$$Ih = \frac{Rc\,c}{Rc\,o}$$

wherein Rec is an abundance ratio of carbon-carbon bonds to total carbon-element bonds, and Rco is an abundance ratio of carbon-oxygen bonds to total carbon-element bonds.

FIG. 1A

100

FIG. 1B

A

FIG. 2

100

FIG. 3

100

20   30   10

13

FIG. 4

100

30

10

FIG. 5

100

40

20   30

21   22

10

## EUROPEAN SEARCH REPORT

**Application Number**

EP 25 21 1743

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 11 967 542 B2 (ABSOLICS INC [US]) 23 April 2024 (2024-04-23) * claim 1; figure 6 * | 1-15 | INV. C03C3/076 C03B1/00 C03C15/00 C03C17/36 C03C17/38 |
| Y | US 11 437 308 B2 (ABSOLICS INC [US]) 6 September 2022 (2022-09-06) * Experimental examples; column 19; claim 1; figure 6 * | 1-15 | |
| Y | US 2022/059421 A1 (KIM SUNGJIN [US] ET AL) 24 February 2022 (2022-02-24) * paragraphs [0075], [0078]; claim 1; figure 5 * | 1-15 | |
| Y | SAVARD M E ET AL: "THE EFFECTS OF PARTICLE SIZE AND ADDITIONS OF NA2SO4 AND NANO3 ON THE REACTIONS IN SODA-LIME-SILICA GLASS BATCHES", GLASS TECHNOLOGY, SOCIETY OF GLASS TECHNOLOGY, SHEFFIELD, GB, vol. 34, no. 5, 1 October 1993 (1993-10-01), pages 210-219, XP000396073, ISSN: 0017-1050 * pages 210-211 * | 1-15 | **TECHNICAL FIELDS SEARCHED (IPC)** C03C C03B B32B |

The present search report has been drawn up for all claims

| Place of search | Date of completion of the search | Examiner |
|---|---|---|
| Munich | 5 March 2026 | Saldamli, Saltuk |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 1743

This annex lists the patent family members relating to the patent documents cited in the above-mentioned European search report.
The members are as contained in the European Patent Office EDP file on
The European Patent Office is in no way liable for these particulars which are merely given for the purpose of information.

05-03-2026

| Patent document cited in search report | | Publication date | Patent family member(s) | | Publication date |
|---|---|---|---|---|---|
| US 11967542 | B2 | 23-04-2024 | CN | 113272951 A | 17-08-2021 |
| | | | EP | 3916772 A1 | 01-12-2021 |
| | | | JP | 7254930 B2 | 10-04-2023 |
| | | | JP | 2022523897 A | 27-04-2022 |
| | | | KR | 20210068580 A | 09-06-2021 |
| | | | US | 2022148942 A1 | 12-05-2022 |
| | | | WO | 2020185021 A1 | 17-09-2020 |
| US 11437308 | B2 | 06-09-2022 | CN | 113383413 A | 10-09-2021 |
| | | | CN | 114678344 A | 28-06-2022 |
| | | | EP | 3910667 A1 | 17-11-2021 |
| | | | ES | 3041275 T3 | 11-11-2025 |
| | | | JP | 7087205 B2 | 20-06-2022 |
| | | | JP | 7588114 B2 | 21-11-2024 |
| | | | JP | 2022123003 A | 23-08-2022 |
| | | | JP | 2022517062 A | 04-03-2022 |
| | | | KR | 20210071074 A | 15-06-2021 |
| | | | KR | 20210130241 A | 29-10-2021 |
| | | | PL | 3910667 T3 | 12-11-2025 |
| | | | US | 2021398891 A1 | 23-12-2021 |
| | | | WO | 2020204473 A1 | 08-10-2020 |
| US 2022059421 | A1 | 24-02-2022 | CN | 113261093 A | 13-08-2021 |
| | | | EP | 3913662 A1 | 24-11-2021 |
| | | | JP | 7599518 B2 | 13-12-2024 |
| | | | JP | 2022523898 A | 27-04-2022 |
| | | | JP | 2023103353 A | 26-07-2023 |
| | | | KR | 20210071075 A | 15-06-2021 |
| | | | KR | 20230074611 A | 30-05-2023 |
| | | | US | 2022059421 A1 | 24-02-2022 |
| | | | US | 2025096055 A1 | 20-03-2025 |
| | | | WO | 2020185023 A1 | 17-09-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63714155

- US 63714157